# EUROPEAN PATENT APPLICATION

(11) **EP 4 502 781 A1**
(43) Date of publication of application: **05.02.2025**
(21) Application number: 23814933.0
(22) Date of filing: 12.05.2023
(51) Int. Cl.: G06F 3/16

(54) **AUDIO PLAYBACK METHOD AND APPARATUS, AND ELECTRONIC DEVICE**

(30) Priority: 30.05.2022 CN 202210599772
(71) Applicant: Huawei Technologies Co., Ltd., Shenzhen, Guangdong 518129 (CN)
(72) Inventor: LIU, Rongliang, Shenzhen, Guangdong 518129 (CN); JIN, Chenyang, Shenzhen, Guangdong 518129 (CN); BAI, Haili, Shenzhen, Guangdong 518129 (CN)
(74) Representative: Grünecker Patent- und Rechtsanwälte PartG mbB
(86) International application number: PCT/CN2023/094003
(87) International publication number: WO 2023/231748

(57) **Abstract**

This application provides an audio playing method and apparatus, and an electronic device. In embodiments, an audio playing application is invoked to decode an audio stream to obtain first audio data; the first audio data is buffered in a memory; a first data amount of the first audio data buffered in the memory is detected; and when the first data amount is greater than a preset first threshold, invoking the audio playing application to decode the audio stream is suspended. Therefore, according to the technical solutions provided in embodiments of this application, the electronic device can suspend invoking the audio playing application in most of time and ensure continuity of audio playing, to further reduce power consumption of the electronic device.

## Description

This application claims priority to Chinese Patent Application No. 202210599772.6, filed with the China National Intellectual Property Administration on May 30, 2022 and entitled "AUDIO PLAYING METHOD AND APPARATUS, AND ELECTRONIC DEVICE", which is incorporated herein by reference in its entirety.

### TECHNICAL FIELD

This application relates to the field of multimedia technologies, and in particular, to an audio playing method and apparatus, and an electronic device.

### BACKGROUND

With development of multimedia technologies, multimedia audio becomes an indispensable part of people's life. An electronic device is a carrier for playing multimedia audio, and the electronic device can meet requirements that people can enjoy music, watch a video, and listen to a book anytime and anywhere. Therefore, power consumption of a power supply of the electronic device also receives wide attention.

Currently, to enjoy better audio quality, a user usually uses an audio playing application to play audio. However, in a conventional technology, when the audio playing application is used to play audio, an application processor (Application Processor, AP) needs to continuously invoke the audio playing application, and this increases power consumption of the electronic device in a screen-off state.

### SUMMARY

Embodiments of this application provide an audio playing method and apparatus, and a system, so that an electronic device can continuously play audio without invoking an audio playing application, to reduce power consumption of the electronic device.

According to a first aspect, an embodiment of this application provides an audio playing method, applied to an electronic device, where the electronic device includes a memory, and the method includes:
invoking an audio playing application to decode an audio stream, to obtain first audio data;
buffering the first audio data to the memory;
detecting a first data amount of the first audio data buffered in the memory; and
when the first data amount is greater than a preset first threshold, suspending invoking the audio playing application to decode the audio stream.

In this embodiment of this application, the audio data is buffered in the memory. In this way, when a data amount of the audio data buffered by the electronic device to the memory is greater than a preset first threshold, the electronic device may suspend invoking the audio playing application, and perform audio playing only by using the audio data buffered in the memory. This reduces power consumption of the electronic device.

In some embodiments, when the electronic device is in a screen-off state, the audio playing apparatus detects a first data amount of the first audio data buffered to the memory, and when the first data amount is greater than a preset first threshold, suspend invoking the audio playing application to decode the audio stream. In this way, when the electronic device is in the screen-off state, the electronic device may suspend invoking the audio playing application, and play audio only by using the audio data buffered in the memory, and this reduces power consumption of the electronic device. If the electronic device does not need to run another application, the electronic device may enter a sleep state, to reduce power consumption of the electronic device.

In a possible implementation, the method further includes:
when suspending invoking the audio playing application, detecting a second data amount of the first audio data read from the memory; and
when the second data amount is greater than a preset second threshold, invoking the audio playing application to decode the audio stream.

In this way, when power consumption of the electronic device is reduced, continuity of audio playing can be further ensured, and user experience is improved.

In a possible implementation, the electronic device buffers the first audio data, the first audio data includes a plurality of audio frames and a timestamp corresponding to each of the plurality of audio frames, and the method further includes:
receiving a sound effect switching request;
in response to the sound effect switching request, determining a first timestamp corresponding to a first audio frame for starting sound effect switching;
determining second audio data from the first audio data based on the first timestamp and a preset offset length;
performing sound effect processing on the second audio data to obtain third audio data;
buffering fourth audio data to the memory based on the offset length and the third audio data, where the third audio data includes the fourth audio data;
reading the fourth audio data from the memory; and
playing audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the determining second audio data from the first audio data based on the first timestamp and a preset offset length includes:
calculating a second timestamp based on the first timestamp and the preset offset length, where the second timestamp is less than the first timestamp; and
determining the second audio data from the first audio data based on the second timestamp.

In a possible implementation, the method further includes:
sending a data deletion instruction to the memory, so that the memory deletes first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

According to a second aspect, an embodiment of this application provides an audio playing method, applied to an electronic device. The electronic device includes an application processor, a memory, and a digital signal processor, the memory is separately coupled to the application processor and the digital signal processor, the application processor is coupled to the digital signal processor, the application processor is configured to run an audio playing application, and the method includes:
invoking, by the application processor, the audio playing application to decode an audio stream to obtain first audio data, and sending the first audio data to the memory, so that the memory buffers the first audio data;
reading, by the digital signal processor, the first audio data from the memory, and performing audio mixing on the first audio data, to obtain fifth audio data, so that the electronic device plays audio based on the fifth audio data; and
detecting, by the application processor, a first data amount of the first audio data sent to the memory, and when the first data amount is greater than a preset first threshold, suspending, by the application processor, invoking the audio playing application.

In this embodiment of this application, the audio data is buffered in the memory. In this way, when a data amount of the audio data buffered by the application processor into the memory is greater than the preset first threshold, the application processor may suspend invoking the audio playing application, so that the electronic device performs audio playing only by using the audio data buffered in the memory, to reduce power consumption of the electronic device.

In some embodiments, when the electronic device is in a screen-off state, the audio playing apparatus detects a first data amount of the first audio data buffered to the memory, and when the first data amount is greater than a preset first threshold, suspend invoking the audio playing application to decode the audio stream. In this way, when the electronic device is in the screen-off state, the application processor may suspend invoking the audio playing application, and play audio only by using the audio data buffered in the memory, and this reduces power consumption of the electronic device. If the application processor does not need to run another application, the application processor may enter a sleep state, to reduce power consumption of the electronic device.

In a possible implementation, the method further includes:
when the application processor suspends invoking the audio playing application, the digital signal processor detects a second data amount of the first audio data read by the digital signal processor from the memory, and when the second data amount is greater than a preset second threshold, sending a wake-up instruction to the application processor; and
in response to the wake-up instruction, invoking, by the application processor, the audio playing application to decode the audio stream, to obtain the first audio data, so as to send the first audio data to the memory.

In this way, when power consumption of the electronic device is reduced, continuity of audio playing can be further ensured, and user experience is improved.

In a possible implementation, the application processor buffers the first audio data, the first audio data includes a plurality of audio frames and a timestamp corresponding to each of the plurality of audio frames, and the method further includes:
receiving, by the application processor, a sound effect switching request, and sending a sound effect switching instruction to the digital signal processor in response to the sound effect switching request;
determining, by the digital signal processor based on the sound effect switching instruction, a first timestamp corresponding to a first audio frame for starting sound effect switching, and sending the first timestamp to the application processor;
determining, by the application processor, second audio data from the first audio data based on the first timestamp and a preset offset length, performing sound effect processing on the second audio data, to obtain third audio data, and sending fourth audio data to the memory based on the offset length and the third audio data, where the third audio data includes the fourth audio data; and
reading, by the digital signal processor, the fourth audio data from the memory, so that the electronic device plays audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the determining second audio data from the first audio data based on the first timestamp and a preset offset length includes:
calculating a second timestamp based on the first timestamp and the preset offset length, where the second timestamp is less than the first timestamp; and
determining the second audio data from the first audio data based on the second timestamp.

In a possible implementation, the method further includes:
sending, by the application processor, a data deletion instruction to the memory; and
deleting, by the memory, first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

In a possible implementation, the method further includes:
receiving, by the application processor, an audio playing request, sending the first audio data to the memory in response to the audio playing request, and sending a data write instruction to the digital signal processor, where the data write instruction indicates that the application processor writes the first audio data to the memory; and
reading, by the audio data signal processor, the first audio data from the memory in response to the data write instruction.

According to a third aspect, an embodiment of this application provides an audio playing apparatus, applied to an electronic device, where the electronic device includes a memory, and the apparatus includes:
an invoking module, configured to invoke an audio playing application to decode an audio stream, to obtain first audio data;
a buffer module, configured to buffer the first audio data to the memory; and
a detection module, configured to detect a first data amount of the first audio data buffered in the memory, where
the invoking module is further configured to: when the first data amount is greater than a preset first threshold, suspend invoking the audio playing application.

When the electronic device suspends invoking the audio playing application, the electronic device is configured to play audio based on the first audio data buffered in the memory.

In this embodiment of this application, the audio data is buffered in the memory. In this way, when a data amount of the audio data buffered by the electronic device to the memory is greater than a preset first threshold, the electronic device may suspend invoking the audio playing application, and perform audio playing only by using the audio data buffered in the memory. This reduces power consumption of the electronic device.

In some embodiments, when the electronic device is in a screen-off state, the audio playing apparatus detects a first data amount of the first audio data buffered to the memory, and when the first data amount is greater than a preset first threshold, suspend invoking the audio playing application to decode the audio stream. In this way, when the electronic device is in the screen-off state, the electronic device may suspend invoking the audio playing application, and play audio only by using the audio data buffered in the memory, and this reduces power consumption of the electronic device. If the electronic device does not need to run another application, the electronic device may enter a sleep state, to reduce power consumption of the electronic device.

In a possible implementation, the detection module is further configured to: when suspending invoking the audio playing application, detect a second data amount of the first audio data read from the memory.

The invoking module is further configured to: when the second data amount is greater than a preset second threshold, invoke the audio playing application to decode the audio stream.

In this way, when power consumption of the electronic device is reduced, continuity of audio playing can be further ensured, and user experience is improved.

In a possible implementation, the electronic device buffers the first audio data, the first audio data includes a plurality of audio frames and a timestamp corresponding to each of the plurality of audio frames, and the apparatus further includes:
a receiving module, configured to receive a sound effect switching request;
a determining module, configured to determine, in response to the sound effect switching request, a first timestamp corresponding to a first audio frame for starting sound effect switching, where
the determining module is further configured to determine second audio data from the first audio data based on the first timestamp and a preset offset length;
a processing module, configured to perform sound effect processing on the second audio data to obtain third audio data, where
the buffer module is further configured to buffer fourth audio data to the memory based on the offset length and the third audio data, where the third audio data includes the fourth audio data;
a reading module, configured to read the fourth audio data from the memory; and
a play module, configured to play audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the determining module is configured to:
calculate a second timestamp based on the first timestamp and the preset offset length, where the second timestamp is less than the first timestamp; and
determine the second audio data from the first audio data based on the second timestamp.

In a possible implementation, the apparatus further includes:
a deletion module, configured to send a data deletion instruction to the memory, so that the memory deletes first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

According to a fourth aspect, an embodiment of this application provides an electronic device, including:
an application processor, configured to invoke an audio playing application to decode an audio stream, to obtain first audio data;
a memory, coupled to the application processor, and configured to buffer the first audio data;
a digital signal processor, separately coupled to the application processor and the memory, and configured to read the first audio data from the memory, and perform audio mixing on the first audio data to obtain fifth audio data, so that the electronic device plays audio based on the fifth audio data, where
the application processor is further configured to detect a first data amount of the first audio data sent to the memory, and when the first data amount is greater than a preset first threshold, suspend invoking the audio playing application.

In this embodiment of this application, the audio data is buffered in the memory. In this way, when a data amount of the audio data buffered by the application processor into the memory is greater than the preset first threshold, the application processor may suspend invoking the audio playing application, so that the electronic device performs audio playing only by using the audio data buffered in the memory, to reduce power consumption of the electronic device.

In some embodiments, when the electronic device is in a screen-off state, the audio playing apparatus detects a first data amount of the first audio data buffered to the memory, and when the first data amount is greater than a preset first threshold, suspend invoking the audio playing application to decode the audio stream. In this way, when the electronic device is in the screen-off state, the application processor may suspend invoking the audio playing application, and play audio only by using the audio data buffered in the memory, and this reduces power consumption of the electronic device. If the application processor does not need to run another application, the application processor may enter a sleep state, to reduce power consumption of the electronic device.

In a possible implementation, the digital signal processor is further configured to: when the application processor suspends invoking the audio playing application, detect a second data amount of the first audio data read by the digital signal processor from the memory, and when the second data amount is greater than a preset second threshold, send a wake-up instruction to the application processor.

The application processor is configured to: in response to the wake-up instruction, continue to invoke the audio playing application to decode the audio stream, to obtain the first audio data.

In this way, when power consumption of the electronic device is reduced, continuity of audio playing can be further ensured, and user experience is improved.

In a possible implementation, that the application processor buffers the first audio data, the first audio data includes a plurality of audio frames and a timestamp corresponding to each of the plurality of audio frames includes:
the application processor is further configured to: receive a sound effect switching request, and send a sound effect switching instruction to the digital signal processor in response to the sound effect switching request;
the digital signal processor is further configured to: determine, based on the sound effect switching instruction, a first timestamp corresponding to a first audio frame for starting sound effect switching, and send the first timestamp to the application processor;
the application processor is further configured to: determine second audio data from the first audio data based on the first timestamp and a preset offset length, perform sound effect processing on the second audio data to obtain third audio data, and send fourth audio data to the memory based on the offset length and the third audio data, where the third audio data includes the fourth audio data; and
the digital signal processor is further configured to read the fourth audio data from the memory, so that the electronic device plays audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the application processor is specifically configured to:
calculate a second timestamp based on the first timestamp and the preset offset length, where the second timestamp is less than the first timestamp; and
determine the second audio data from the first audio data based on the second timestamp.

In a possible implementation, the application processor is further configured to send a data deletion instruction to the memory.

The memory is further configured to delete first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

In a possible implementation, the application processor is further configured to receive an audio playing request, send the first audio data to the memory in response to the audio playing request, and send a data write instruction to the digital signal processor, where the data write instruction indicates that the application processor writes the first audio data to the memory.

The audio data signal processor is further configured to start reading the first audio data from the memory in response to the data write instruction.

According to a fourth aspect, an embodiment of this application provides an audio processing system. The system may include an application processor, a memory, and a digital signal processor. The system is configured to perform the method according to any one of the first aspect or the possible implementations of the first aspect, or perform the method according to any one of the second aspect or the possible implementations of the second aspect.

According to a fifth aspect, an embodiment of this application provides an electronic device, including: at least one memory, configured to store a program; and at least one processor, configured to execute the program stored in the memory. When the program stored in the memory is executed, the processor is configured to perform the method according to any one of the first aspect or the possible implementations of the first aspect, or perform the method according to any one of the second aspect or the possible implementations of the second aspect.

According to a sixth aspect, an embodiment of this application provides a computer storage medium. The computer storage medium stores a computer program. When the computer program is run in an electronic device, the electronic device is enabled to perform the method according to any one of the first aspect or the possible implementations of the first aspect, or perform the method according to any one of the second aspect or the possible implementations of the second aspect.

According to a seventh aspect, an embodiment of this application provides a computer program product including instructions. The computer program product is used to store a computer program. When the computer program is run on a computer, the computer is enabled to perform the method according to any one of the first aspect or the possible implementations of the first aspect.

### BRIEF DESCRIPTION OF DRAWINGS

FIG. 1 is a system architecture diagram of an audio processing system in a conventional technology according to an embodiment of this application;
FIG. 2 is a schematic diagram of a hardware structure of an electronic device according to an embodiment of this application;
FIG. 3 is a system architecture diagram of an audio processing system according to an embodiment of this application;
FIG. 4 is a schematic diagram of a software structure of an electronic device according to an embodiment of this application;
FIG. 5 is a schematic flowchart of an audio playing method according to an embodiment of this application;
FIG. 6 is a schematic flowchart of a sound effect switching method according to an embodiment of this application;
FIG. 7 is another schematic flowchart of an audio playing method according to an embodiment of this application;
FIG. 8 is another schematic flowchart of a sound effect switching method according to an embodiment of this application;
FIG. 9 is a schematic diagram of a structure of an audio playing apparatus according to an embodiment of this application; and
FIG. 10 is a schematic diagram of a structure of an electronic device according to an embodiment of this application.

### DESCRIPTION OF EMBODIMENTS

To make objectives, technical solutions, and advantages of embodiments of this application clearer, the following describes the technical solutions in embodiments of this application with reference to accompanying drawings.

In the description of embodiments of this application, words such as "an example", "for example", or "for example" are used to represent an example, an illustration, or a description. Any embodiment or design solution described as "an example", "for example", or "for example" in embodiments of this application should not be interpreted as being more preferred or advantageous than another embodiment or design solution. Specifically, the use of the words such as "an example", "for example", or "for example" is intended to present related concepts in a specific manner.

In the description of embodiments of this application, the term "and/or" is merely an association relationship for describing associated objects, and indicates that three relationships may exist. For example, A and/or B may indicate: only A exists, only B exists, and both A and B exist. In addition, unless otherwise specified, the term "multiple" means two or more. For example, a plurality of systems refers to at least two systems, and a plurality of terminals refers to at least two terminals.

In addition, terms "first" and "second" are merely used for a description purpose, and shall not be understood as indicating or implying relative importance or implicitly including indicated technical features. Therefore, a feature limited by "first" or "second" may explicitly or implicitly include one or more features. The terms "include", "have", and their variants all mean "include but are not limited to", unless otherwise specifically emphasized in another manner.

With development of multimedia technologies, multimedia audio becomes an indispensable part of people's life. An electronic device is a carrier for playing multimedia audio, and the electronic device can meet requirements that people can enjoy music, watch a video, and listen to a book anytime and anywhere. Therefore, power consumption of a power supply of an electronic device also receives wide attention.

Currently, a user installs an audio playing application on the electronic device based on a requirement of the user, and more often selects to play audio by using the audio playing application. In a conventional technology, when the user plays the audio by using the audio playing application, even if the electronic device is in a screen-off state, to ensure continuity of audio playing, the electronic device needs to continuously invoke the audio playing application to process audio data, and this increases power consumption of the electronic device.

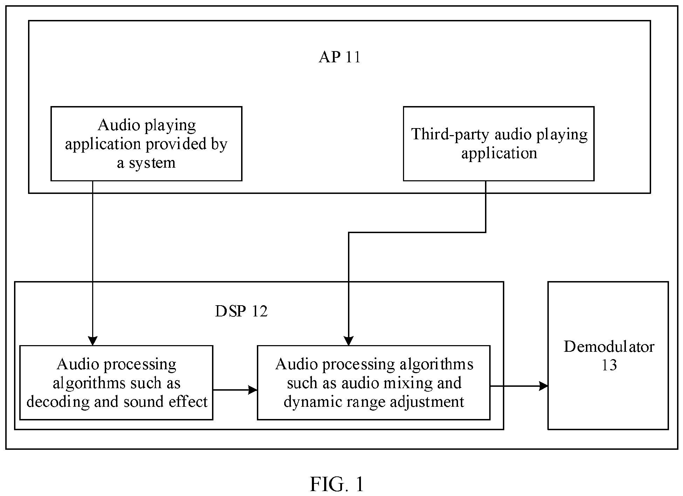

For example, as shown in FIG. 1, modules for processing audio data in the electronic device include an application processor (Application Processor, AP) 11, a digital signal processor (Digital Signal Processor, DSP) 12, and a demodulator 13. The application processor 11 may run a third-party audio playing application and an audio playing application provided by a system. The user may play audio by using the third-party audio playing application, or may play audio by using the audio playing application provided by the system. When the user plays audio by using the third-party audio playing application, the AP 11 performs related preprocessing on audio data by invoking an algorithm provided by the third-party audio playing application, for example, parsing an audio stream into an elementary stream (Elementary Stream, ES), decoding the ES stream, and adding preprocessing such as a sound effect and audio mixing. The AP 11 sends the processed audio data to the DSP 12 for processing, for example, processing such as audio mixing and dynamic range adjustment. The DSP 12 sends the processed audio data to the demodulator 13 for demodulation. In this way, audio may be played based on the demodulated audio data. However, the third-party audio playing application has its own audio data processing algorithm, for example, a sound effect processing algorithm and an audio mixing algorithm, and the audio data processing algorithm of the third-party audio playing application is stored in the AP 11 with installation of the third-party audio playing application, and cannot be stored in the DSP 12. Therefore, in a process of playing audio by the third-party audio playing application, the AP 11 needs to always keep in a power-on state, to continuously invoke the audio processing algorithm provided by the third-party audio playing application to preprocess the audio data. An audio processing algorithm of the audio playing application provided by the system is stored in the DSP 12. The audio playing application provided by the system needs to send unprocessed audio data to the DSP 12, and the DSP 12 processes the audio data by using the stored audio processing algorithm corresponding to the audio playing application provided by the system.

In this way, in a process of playing audio by the third-party audio playing application, even when the electronic device is in a screen-off state, the AP 11 is still in the power-on state (the third-party audio playing application is invoked to process the audio data), so that the audio can be played continuously, and power consumption of the AP in the screen-off state is increased. However, the audio processing algorithm of the audio playing application provided by the system is stored in the DSP 12. Storage space of the DSP 12 is limited, and an audio processing algorithm of audio data in more formats cannot be supported, and flexibility is poor.

Therefore, in this embodiment of this application, the audio processing algorithm of the audio playing application provided by the system is transplanted to the application processor, and audio data decoded by the audio playing application (the third-party audio playing application and the audio playing application provided by the system) invoked by the application processor is stored in a memory of the electronic device. Therefore, when the electronic device is in the screen-off state, the application processor can suspend invoking the third-party audio playing application for more time, the electronic device can further continuously play audio, and this reduces power consumption of the electronic device. In addition, the audio processing algorithm of the audio playing application provided by the system is transplanted to the application processor, so that an audio processing algorithm with a plurality of audio formats can be deployed, and flexibility of playing audio by using the audio playing application provided by the system is improved.

Based on this, embodiments of this application provide an audio playing method and apparatus, and an electronic device, so that the electronic device can continuously play audio without invoking an audio playing application, to reduce power consumption of the electronic device.

It may be understood that the electronic device recorded in embodiments of this application may be a mobile phone, a tablet computer, a wearable device, a smart television, a Huawei vision, a smart speaker, an in-vehicle application, or the like. An example embodiment of the electronic device includes but is not limited to an electronic device running iOS, Android, Windows, Harmony OS (Harmony OS), or another operating system. A type of the electronic device is not specifically limited in embodiments of this application.

The following describes the electronic device provided in embodiments of this application.

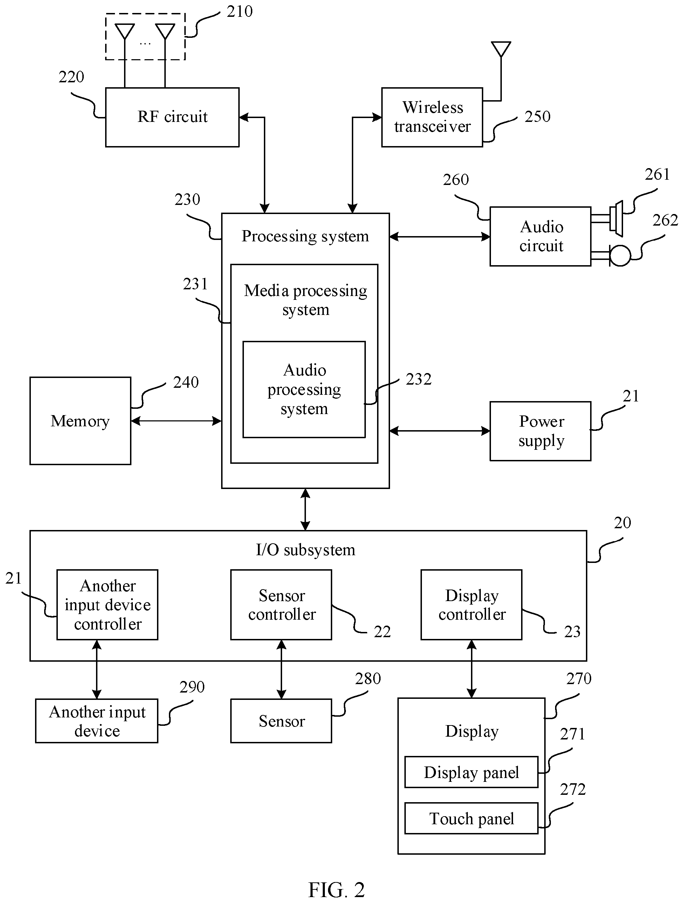

FIG. 2 is a schematic diagram of a hardware structure of an electronic device 200 according to an embodiment of this application. As shown in FIG. 2, the electronic device provided in this embodiment of this application may include an antenna system 210. The antenna system 210 may be one or more antennas, or the antenna system 210 may be an antenna array including a plurality of antennas. The electronic device 200 may further include a radio frequency (Radio Frequency, RF) circuit 220. The radio frequency circuit 220 may include one or more analog radio frequency transceivers. The radio frequency circuit 220 may further include one or more digital radio frequency transceivers. The RF circuit 220 is coupled to the antenna system 210. It should be noted that in embodiments of this application, coupling refers to an interrelationship in a particular manner, and includes direct connection or indirect connection through another device like various interfaces, transmission lines, or buses. The radio frequency circuit 220 may be configured for various types of cellular wireless communication.

The electronic device 200 may further include a processing system 230. The processing system 230 may include a communication processor. The communication processor may be configured to control the RF circuit 220 to receive and send a signal by using the antenna system 210. The signal may be an audio signal, a media signal, or a control signal. The communication processor in the processing system 230 may be further configured to manage the foregoing signal. Specifically, signal management herein may include signal enhancement, signal filtering, encoding/decoding, signal modulation, signal mixing, signal separation, or other known signal processing processes, and a new signal processing process that may occur in the future. The processing system 230 may include various processing devices, for example, may be a central processing unit (Central Processing Unit, CPU), a system on chip (System on Chip, SOC), a processor integrated on the SOC, a separate processor chip, or a controller. The processing system 230 may further include a dedicated processing device, for example, an application-specific integrated circuit (Application-Specific Integrated Circuit, ASIC), a field programmable gate array (Field Programmable Gate Array, FPGA), or a digital signal processor (Digital Signal Processor, DSP). The processing system 230 may be a processor group including a plurality of processors, and the plurality of processors are coupled to each other through one or more buses. The processing system may include an analog-to-digital converter (Analog-to-Digital Converter, ADC) and a digital-to-analog converter (Digital-to-Analog Converter, DAC), to implement signal connection between different components. For example, an analog audio signal collected by a microphone may be converted into a digital audio signal by using the ADC, and the digital audio signal is transmitted to the digital signal processor for processing, or a digital audio signal in a processor may be converted into an analog audio signal by using the DAC, and the analog audio signal is played by using a speaker. The processing system may include a media processing system 231. The media processing system is configured to process media signals such as an image, audio, and a video. Specifically, the media processing system 231 may include an audio processing system 232. Specifically, the audio processing system 232 may be a general-purpose or dedicated audio processing device, for example, may be an audio processing subsystem integrated on the SOC, or may be an audio processing module integrated on a processor chip. Optionally, the audio processing module may be a software module or a hardware module, and the audio processing module may alternatively be one or more independent audio processing chips. The audio processing system 232 is configured to implement related processing of an audio signal.

The electronic device 200 may further include a memory 240, and the memory 240 is coupled to the processing system 230. Specifically, the memory 240 may be coupled to the processing system 230 by using one or more memory controllers. The memory 240 may be configured to store computer program instructions, including a computer operating system (Operating System, OS) and various user applications, for example, an audio processing program with an audio mixing function, an application with a live broadcast function, a video player, a music player, and another possible application. The memory 240 may be further configured to store user data, for example, calendar information, contact information, obtained image information, audio information, or another media file. The processing system 230 may read the computer program instructions or the user data from the memory 140, or store the computer program instructions or the user data in the memory 240, to implement a related processing function. For example, the audio file in the memory 240 may be read to the processor for audio stream conversion, decoding, audio mixing, encoding, and the like, or the audio file stored in the memory 240 is read by using a processing system and a music player is invoked to play a series of operations. The memory 240 may be a non-volatile memory, for example, an embedded multimedia card (Embedded MultiMedia Card, EMMC), a universal flash storage (Universal Flash Storage, UFS), or a read-only memory (Read-Only Memory, ROM), or another type of static storage device that can store static information and instructions, or may be a volatile memory (volatile memory), for example, a random access memory (Random Access Memory, RAM), or another type of dynamic storage device that can store information and instructions, or may be an electrically erasable programmable read-only memory (Electrically Erasable Programmable Read-only Memory, EEPROM), a compact disc read-only memory (Compact Disc Read-Only Memory, CD-ROM), or another optical disc storage, an optical disc storage (including a compact disc, a laser disc, an optical disc, a digital versatile disc, a Blu-ray disc, and the like), a magnetic disk storage medium or another magnetic storage device, or any other computer-readable storage medium that can be used to carry or store program code in a form of instructions or a data structure and that can be accessed by a computer, but is not limited thereto. The memory 240 may exist independently, or the memory 240 may be integrated with a processing system.

The electronic device 200 may further include a wireless transceiver 250. The wireless transceiver 250 may provide a wireless connection capability for another device. The another device may be a peripheral device like a wireless headset, a Bluetooth headset, a wireless mouse, or a wireless keyboard, or may be a wireless network, for example, a wireless fidelity (Wireless Fidelity, Wi-Fi) network, a wireless personal area network (Wireless Personal Area Network, WPAN), or another wireless local area network (Wireless Local Area Network, WLAN). The wireless transceiver 250 may be a Bluetooth-compatible transceiver, and is configured to wirelessly couple the processing system 230 to the peripheral device such as the Bluetooth headset or the wireless mouse, or the wireless transceiver 250 may be a Wi-Fi-compatible transceiver, and is configured to wirelessly couple the processing system 230 to the wireless network or another device.

The electronic device 200 may further include an audio circuit 260, and the audio circuit 260 is coupled to the processing system 230. The audio circuit 260 may include a microphone 261 and a speaker 262. The microphone 261 may receive a sound input from the outside. The sound input may be a user audio input, a loudspeaker music input, a noise input, or other forms of sound from the outside. The microphone 261 may be a built-in microphone integrated on the electronic device 200, or may be an external microphone coupled to the electronic device 200 through an interface, for example, may be a headset microphone coupled to the apparatus through a headset interface. The speaker 262 may play audio data. The audio data may come from a microphone, or may be a music file stored in the memory, or an audio stream processed by the processing system. The speaker is a type of audio transducer, and may enhance an audio signal. The speaker may alternatively be replaced with an audio transducer in another form. It should be understood that the electronic device 200 may have one or more microphones and one or more headsets. Quantities of microphones and headsets are not limited in this embodiment of this application. The processing system 230 drives or controls the audio circuit by using an audio controller (not shown in FIG. 2). Specifically, at least one of the microphone or the speaker is enabled or disabled based on instructions of the processing system 230. When an audio signal from the microphone needs to be received, the processing system enables the microphone by using a related control instruction, and receives the audio signal input by the microphone. The audio signal may be processed in the processing system 230, or may be sent to the memory 240 for storage, or played by the speaker, alternatively, the signal may be transmitted to a network or another apparatus by using the RF circuit 220 and by using the antenna system 210, or may be transmitted to a network or another apparatus by using the wireless transceiver 250. When audio needs to be played, the processing system enables the speaker by using a related control instruction, to play the audio signal. Correspondingly, when the microphone and the speaker are not required, the microphone and the speaker are disabled by using the related control instruction.

The electronic device 200 may further include a display 270, configured to display information input by the user and various menus of information provided to the user. These menus are associated with specific modules or functions inside. The display 270 may further receive a user input, for example, receive enabling, disabling, or other control information. Specifically, the display 270 may include a display panel 271 and a touch panel 272. The display panel 271 may be configured by using a liquid crystal display (Liquid Crystal Display, LCD), an organic light-emitting diode (Organic Light-Emitting Diode, OLED), a light-emitting diode (Light-Emitting Diode, LED) display device, a cathode ray tube (Cathode Ray Tube, CRT), or the like. The touch panel 272, also referred to as a touchscreen, a touch-sensitive screen, or the like, may collect a contact or non-contact operation of the user on or near the touch panel 272 (like an operation of the user on or near the touch panel 272 by using any suitable object or accessory such as a finger or a stylus, or a motion sensing operation. The operation includes a single-point control operation, a multi-point control operation, or another type of operation), and drive a corresponding connection apparatus based on a preset program. Optionally, the touch panel 272 may include two parts: a touch detection apparatus and a touch controller. The touch detection apparatus detects a signal brought by a touch operation of the user, and transmits the signal to the touch controller. The touch controller receives touch information from the touch detection apparatus, converts the touch information into information that can be processed by the processing system 230, sends the information to the processing system 230, and can receive and execute a command sent by the processing system 230. Further, the touch panel 272 may cover the display panel 271, and the user may perform, based on content displayed on the display panel 271 (the displayed content includes but is not limited to a soft keyboard, a virtual mouse, a virtual key, and an icon), an operation on or near the touch panel 272 covering the display panel 271. After detecting the operation on or near the touch panel 272, the touch panel 272 transmits the operation to the processing system 230 by using an I/O subsystem 20, to determine a user input. Then the processing system 230 provides a corresponding visual output on the display panel 271 based on the user input by using the I/O subsystem 20. Although in FIG. 2, the touch panel 272 and the display panel 271 act as two independent components to implement input and input functions of the electronic device 200, in some embodiments, the touch panel 272 and the display panel 271 may be integrated to implement the input and output functions of the electronic device 200.

The electronic device 200 may further include one or more sensors 280 coupled to the processing system 230. The sensor 280 may include an image sensor, a motion sensor, a proximity sensor, an ambient noise sensor, a sound sensor, an accelerometer, a temperature sensor, a gyroscope, or another type of sensor, and a combination of various forms thereof. The processing system 230 drives the sensor 280 by using a sensor controller 22 in the I/O subsystem 20 to receive various information such as an audio signal, an image signal, and motion information. The sensor 280 transmits the received information to the processing system 230 for processing.

The electronic device 200 may further include another input device 290 coupled to the processing system 230 to receive various user inputs, for example, receiving an input number, name, address, and media selection, where the media may be any file with audio, such as a music file, a video file, and another audio file. For another example, operations such as sound effect switching and audio switching in a process in which the user plays audio by using an audio playing application may be further received. The another input device 290 may include a keyboard, a physical button (like a push-button or a rocker button), a dial pad, a slider switch, a joystick, a click scroll wheel, and an optical mouse (the optical mouse is a touch-sensitive surface that does not display visual output, or an extension of a touch-sensitive surface formed by a touchscreen). The user can

The electronic device 200 may further include the foregoing I/O subsystem 20. The I/O subsystem 20 may include another input device controller 21 that is configured to receive a signal from the another input device 290 or send control or drive information of the processing system 230 to the another input device 290. The I/O subsystem 20 may further include the foregoing sensor controller 22 and display controller 23, which are respectively configured to implement data and control information exchange between the sensor 280 and the display 270 and the processing system 230.

The electronic device 200 may further include a power supply 201, to supply power to another component of the electronic device 200 including 210 to 290. The power supply may be a rechargeable or non-chargeable lithium-ion battery or a nickel-hydrogen battery. Further, when the power supply 201 is a rechargeable battery, the power supply 201 may be coupled to the processing system 230 by using a power management system, to implement functions such as charging, discharging, and power consumption adjustment management by using the power management system.

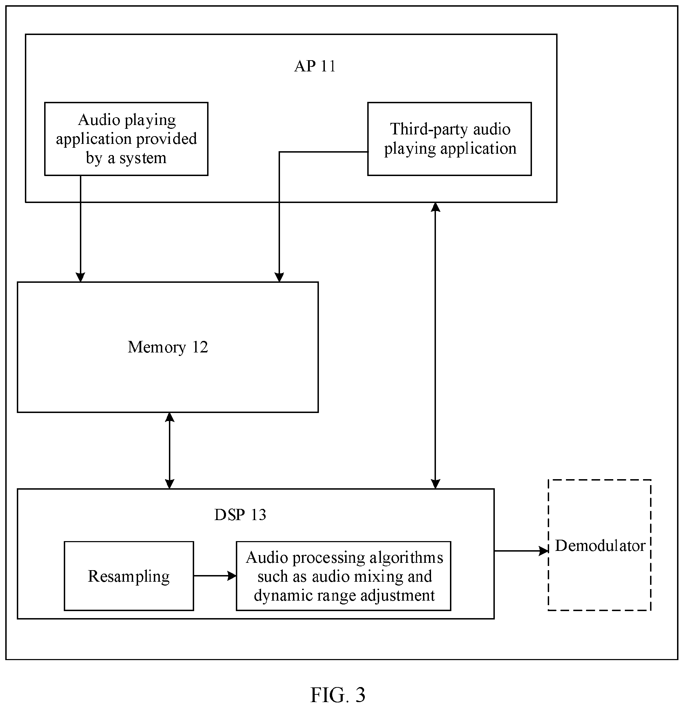

For example, as shown in FIG. 3, an embodiment of this application provides an audio processing system (equivalent to the processing system 230 and the memory 240 that are coupled together in the foregoing embodiment) and may include an application processor 31, a DSP 32, and a memory 33. The application processor 31, the DSP 32, and the memory 33 may be coupled and integrated together. The application processor 31 may run an audio playing application. The memory 33 is configured to store an audio file corresponding to to-be-played audio and an audio algorithm of the audio playing application. When a user uses the audio playing application to play audio, the application processor 31 may invoke the audio file and the audio algorithm of the audio playing application from the memory, and convert the audio file into an ES stream, decode the audio file, and perform audio processing such as a sound effect, to obtain audio data. The application processor 31 sends processed audio data to the memory for storage. The DSP 32 may read the audio data from the memory for corresponding processing, for example, resampling and audio mixing. The DSP 32 sends the processed audio data to a demodulator for demodulation. In this way, the application processor 31 may suspend invoking of the audio playing application, and the DSP 32 may read audio from the memory to perform corresponding processing, to reduce power consumption of the electronic device while ensuring continuous audio playing. If the electronic device is in a screen-off state, and the application processor does not need to run another application, the application processor may enter a sleep state, and this greatly reduces power consumption of the electronic device.

It may be understood that the electronic device 200 in FIG. 2 is merely an example, and constitutes no limitation on a specific form of the electronic device 200. The electronic device 200 may further include other existing or future components that are not shown in FIG. 2.

A software system of the electronic device 200 provided in this embodiment of this application may use a layered architecture, an event-driven architecture, a microkernel architecture, a micro service architecture, or a cloud architecture. In embodiments of this application, an example of an Android system of the hierarchical architecture is used to describe the software structure of the electronic device 200.

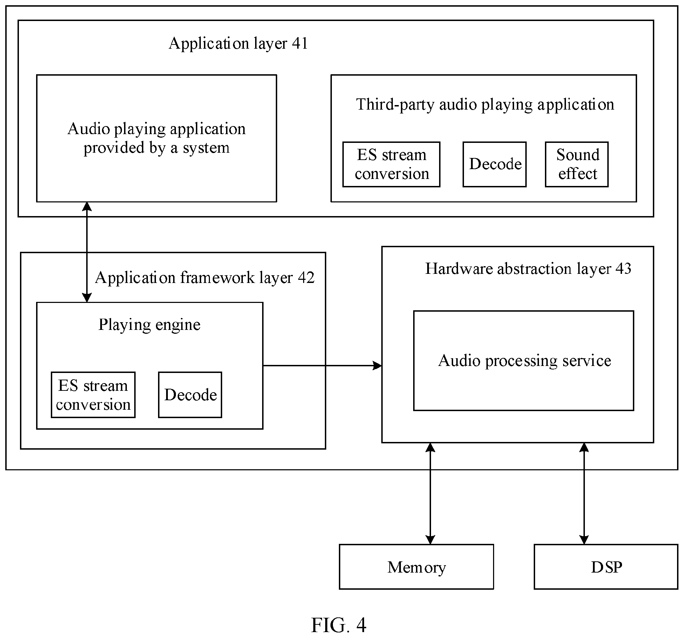

FIG. 4 is a schematic diagram of a software structure of an electronic device 200 according to an embodiment of this application. As shown in FIG. 4, the software architecture of the electronic device 200 provided in this embodiment of this application may include an application layer 41, an application framework layer 42, and a hardware abstraction layer 43. The application layer 41 may run an audio playing application and an audio playing application provided by a system. Herein, in a process of running the audio playing application, the application layer 41 may invoke an audio processing algorithm provided by the audio playing application, to perform corresponding processing on audio data, such as ES stream conversion, decoding, and sound effect processing. The application framework layer 42 includes a play engine, configured to: in a process of playing audio by an audio playing application provided by a system, invoke an audio processing algorithm of the audio playing application provided by the system to perform corresponding processing on the audio data, for example, convert audio data in an audio file into an ES stream, and decode the audio data. In addition to common functions, the hardware abstraction layer 43 is configured to provide some audio processing services. For example, audio data processed by the audio playing application invoked by the application layer 41 is buffered, and the audio data is transmitted to a memory as a transmission medium, and instructions of an application processor are transmitted to a DSP.

It may be understood that the software architecture of the electronic device in FIG. 4 is merely an example provided for the audio processing solution provided in this embodiment of this application, and does not constitute a limitation on the software architecture of the electronic device. The software architecture of the electronic device may further include another existing component or another component that may be added in the future and that is not shown in FIG. 4.

The foregoing describes the electronic device in embodiments of this application. The following describes in detail an audio playing method in an embodiment of this application. It should be noted that the audio playing method mainly describes a process of an application scenario. For details, see the description on this page.

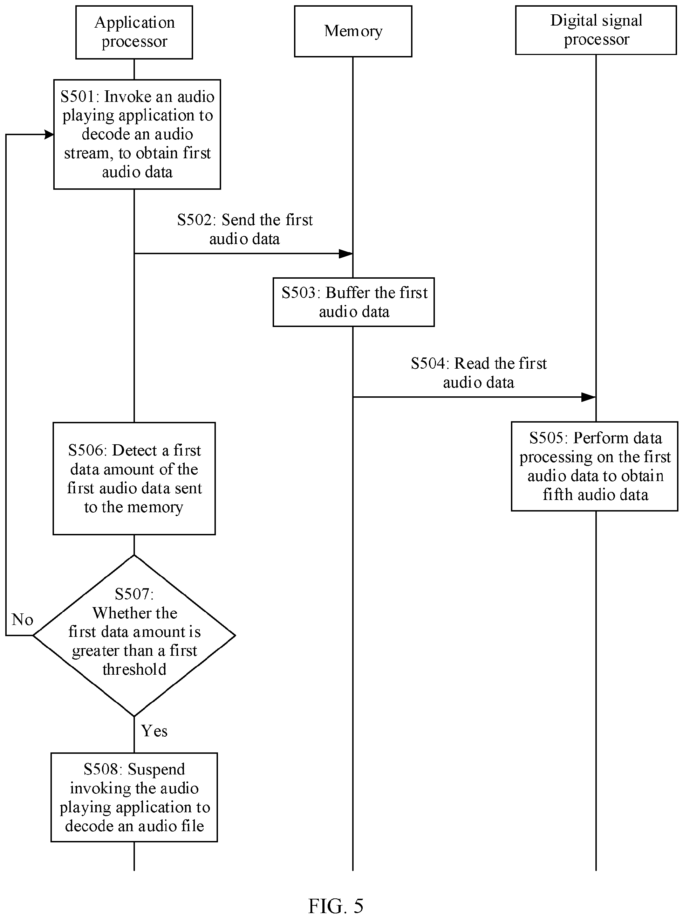

FIG. 5 is a schematic flowchart of an audio playing method according to an embodiment of this application.

As shown in FIG. 5, the audio playing method provided in this embodiment of this application may be applied to the electronic device provided in the embodiment corresponding to FIG. 4. The audio playing method may include S501 to S508.

S501: An application processor invokes an audio playing application to decode an audio stream, to obtain first audio data.

The audio stream is a data stream that records audio data of to-be-played audio. The electronic device may communicate with a server, to obtain an audio file recording the audio data, and convert the audio file into the audio stream. For convenience of audio playing, the electronic device may buffer or download the audio file to a memory based on a user requirement. The application processor may read the audio file from the memory, convert the audio file into the audio stream, and decode the audio stream, to convert compressed audio data into uncompressed audio data, namely, first audio data. Herein, the first audio data refers to audio data obtained by decoding the audio stream by the application processor, and each frame of audio data in an audio data stream sent by the application processor to the memory may be referred to as the first audio data.

Herein, after reading the audio stream from the memory, the application processor may convert the audio stream into an ES stream. Then, the ES stream is decoded. In some cases, sound effect processing may be further performed on the decoded ES stream.

It should be noted that the electronic device continuously plays audio. When the electronic device continuously plays the audio, the application processor may continuously invoke the audio playing application to decode the audio stream, or may stop invoking the audio playing application to decode the audio stream.

S502: The application processor sends the first audio data to the memory.

The application processor is coupled to the memory, and data transmission may be performed between the application processor and the memory through a communication interface. Application processor.

Herein, the application processor further needs to buffer the first audio data, to ensure accuracy of subsequent sound effect switching.

In some embodiments, when the electronic device receives an audio playing operation of a user, so that the application processor starts to invoke the audio playing application, the application processor may further send a data write instruction to a digital signal processor while sending the first audio data to the memory. After receiving the data write instruction, the digital signal processor may read the first audio data from the memory.

S503: The memory buffers the first audio data.

After receiving the first audio data, the memory stores the first audio data.

S504: The digital signal processor reads the first audio data from the memory.

The digital signal processor is coupled to the memory, and may transmit data through the communication interface. The digital signal processor may send a read instruction to the memory, to read the first audio data from the memory.

S505: The digital signal processor performs data processing on the first audio data to obtain fifth audio data.

Herein, there are a plurality of types of data processing, for example, audio data processing such as resampling, audio mixing, and dynamic range compression (Dynamic range compression, DRC) is performed on the first audio data.

The digital signal processor may convert a sampling rate of the audio data, a channel or a bit depth of the first audio data, or the like by resampling the first audio data. In this way, audio playing quality can be improved, to adapt to different audio playing requirements. For example, if a user requires to play high-quality audio, the audio playing quality may be improved through resampling, increasing a sampling frequency, and the like. Both audio mixing and dynamic range compression performed by the digital signal processor on the first audio data can improve an audio playing effect.

Herein, after the digital signal processor obtains the fifth audio data, the electronic device may play audio based on the fifth audio data. The digital signal processor may send the fifth audio data to a demodulator for demodulation, so that an audio playing device can identify the audio data.

S506: The application processor detects a first data amount of the first audio data sent to the memory.

The processor in the electronic device may detect a status of the electronic device, and may be the application processor, or may be another processor in the electronic device. The application processor detects the first data amount of the first audio data sent to the memory. The application processor may calculate, in a process of sending the first audio data in real time, a data amount of accumulated sent first audio data. The application processor may read the first data amount that is of the first audio data accumulated sent to the memory and that is recorded in the application processor, so as to determine, based on the first data amount, whether the audio data stored in the memory can enable the electronic device to continuously play the audio for a period of time.

In some embodiments, when the application processor detects that the electronic device is in a screen-off state or receives an instruction used to indicate that the electronic device is in a screen-off state, the application processor detects the first data amount of the first audio data sent to the memory.

S507: The application processor detects whether the first data amount is greater than a first threshold, and if yes, S508 is performed, or if no, S501 is performed.

The first threshold is set in an audio processing algorithm in the application processor, and values of the first data amount and the first threshold can be detected. When the first data amount is greater than the first threshold, the audio data stored in the memory can enable the electronic device to continuously play the audio for a period of time.

S508: The application processor suspends invoking the audio playing application to decode the audio stream.

When the first data amount of the first audio data sent by the application processor to the memory is greater than the first threshold, the application processor may suspend invoking the audio playing application to decode the audio stream, to suspend sending the first audio data to the memory.

In some embodiments, when the electronic device is in the screen-off state, if the application processor does not run an application other than the audio playing application, the application processor enters a sleep state after suspending invoking the audio playing application (the application processor does not run any application). In this way, the application processor may reduce power consumption of the electronic device or no power consumption when the electronic device is in the screen-off state, to reduce power consumption of the electronic device and improve user experience.

In some embodiments, when the application processor suspends invoking the audio playing application, the application processor may send a suspend invoking instruction to the digital signal processor, where the suspend invoking instruction indicates that the application processor suspends invoking the audio playing application. After receiving the suspend invoking instruction, the digital signal processor may detect a second data amount of the first audio data read from the memory, to determine whether the application processor needs to be woken up to continue to invoke the audio playing application. Specifically, the digital signal processor may detect whether the second data amount is greater than a preset second threshold, and generate a wake-up instruction when the second data amount is greater than the second threshold. The digital signal processor sends the wake-up instruction to the application processor, and the application processor starts to continue invoking the audio playing application to decode the audio stream, to ensure continuity of audio playing.

Generally, to experience different audio effects, the user switches between different sound effects based on the user requirement. Based on the embodiment corresponding to FIG. 5, an embodiment of this application further provides a sound effect switching method, to ensure accuracy of switching a sound effect. For details, see the description on this page.

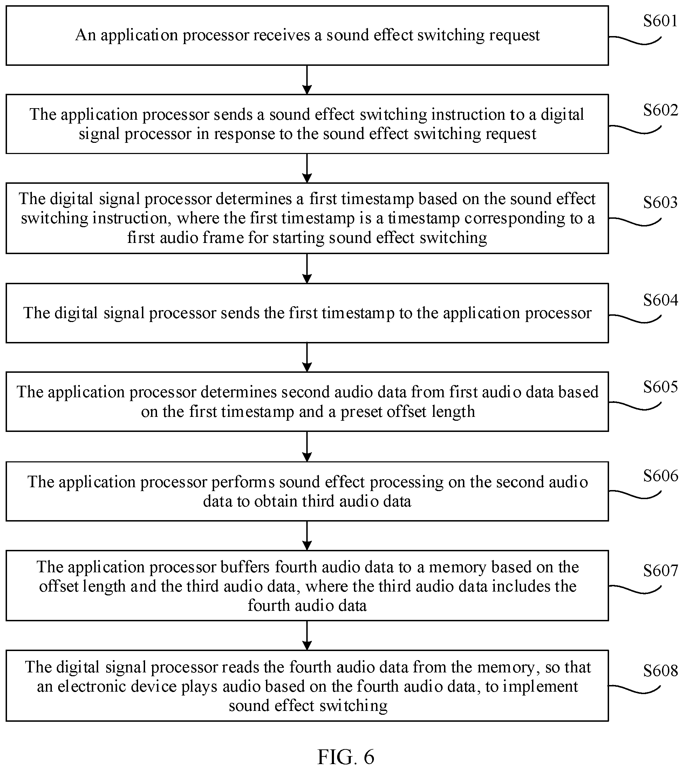

As shown in FIG. 6, a sound effect switching method provided in this embodiment of this application may include S601 to S608.

S601: An application processor receives a sound effect switching request.

A user may perform a sound effect switching operation by using a human-computer interaction interface of an audio playing application, so that the application processor can receive the sound effect switching request. The request may be an instruction used to indicate to switch a sound effect.

S602: The application processor sends a sound effect switching instruction to a digital signal processor in response to the sound effect switching request.

After receiving the sound effect switching request, the application processor sends the sound effect switching instruction to the digital signal processor. The sound effect switching instruction indicates to start to switch an instruction. The sound effect switching instruction may be the sound effect switching request, or may be an instruction generated based on the sound effect switching request.

S603: The digital signal processor determines a first timestamp based on the sound effect switching instruction, where the first timestamp is a timestamp corresponding to a first audio frame for starting sound effect switching.

The first audio data stored in the memory may include a plurality of audio frames, and the first audio data may be time series data. Therefore, each audio frame corresponds to a timestamp, and the timestamp may indicate a sequence of each audio frame. After the digital signal processor receives the sound effect switching instruction, the digital signal processor may determine the first timestamp, where the timestamp is a timestamp at which sound effect switching starts. The first audio frame corresponding to the first timestamp is an audio frame in which sound effect switching starts.

To ensure continuity of audio playing and accuracy of sound effect switching, and ensure user experience, the digital signal processor may determine the first timestamp based on a timestamp corresponding to a currently processed first audio frame. The first timestamp is greater than the timestamp corresponding to the currently processed first audio frame.

S604: The digital signal processor sends the first timestamp to the application processor.

S605: The application processor determines second audio data from the first audio data based on the first timestamp and a preset offset length.

In a sound effect switching process, the electronic device needs to continuously play audio. Therefore, the first timestamp is greater than the timestamp corresponding to the currently processed audio frame, that is, a playing time series of the audio frame for which sound effect switching starts is after the playing time series of the currently processed audio frame. To ensure smoothness and accuracy of sound effect switching, the application processor needs to perform sound effect processing on an audio frame in a time series before the first timestamp, that is, subtract the offset length from the first timestamp to obtain a second timestamp. The application processor performs sound effect switching processing on all audio frames after the second timestamp. It may be understood that the second timestamp is less than the first timestamp.

Herein, the second audio data includes an audio frame after the second timestamp in the first audio data. For example, if the first audio data buffered by the application processor includes n audio frames, and a timestamp corresponding to the 20^{th} audio frame is the second timestamp, the second audio data includes the 21^{st} audio frame to the n^{th} audio frame.

In some embodiments, to save storage space of the memory and avoid disorder of audio playing, the application processor generates a data deletion instruction after obtaining the first timestamp through calculation. The data deletion instruction carries the first timestamp. After receiving the data deletion instruction, the memory deletes first audio data after the first timestamp in the memory, to avoid disorder of audio playing and implement smooth switching of a sound effect.

S606: The application processor performs sound effect processing on the second audio data to obtain third audio data.

The application processor invokes an algorithm corresponding to the audio playing application to perform sound effect processing on the second audio data, to obtain the third audio data.

S607: The application processor buffers fourth audio data to the memory based on the offset length and the third audio data, where the third audio data includes the fourth audio data.

Herein, the third audio data is audio data starting from the second timestamp, and an audio frame corresponding to the offset length may be deleted starting from the first audio frame of the third audio data. For example, if the third audio data includes the 21^{st} audio frame to the n^{th} audio frame, and the offset length is 30, the 21^{st} audio frame to the 51^{st} audio frame are all deleted.

S608: The digital signal processor reads the fourth audio data from the memory, so that the electronic device plays audio based on the fourth audio data, to implement sound effect switching.

The audio data read by the digital signal processor from the memory may be first audio data before sound effect switching, or may be fourth audio data after sound effect switching. When the digital signal processor reads the fourth audio data of the first timestamp, a sound effect of audio played by the electronic device is switched.

In this embodiment of this application, the audio data is buffered in the memory. In this way, when the electronic device is in a screen-off state, and a data amount of the buffered audio data is greater than a preset first threshold, the electronic device may suspend invoking the audio playing application, and perform audio playing only by using the audio data buffered in the memory. This reduces power consumption of the electronic device.

The foregoing describes an audio playing method in an application scenario of this solution. The following describes an audio playing method provided in an embodiment of this application in another application scenario. It should be noted that for some or all of the sound effect processing method provided in this embodiment of this application, refer to the description of the embodiment corresponding to FIG. 5. For details, see the description on this page.

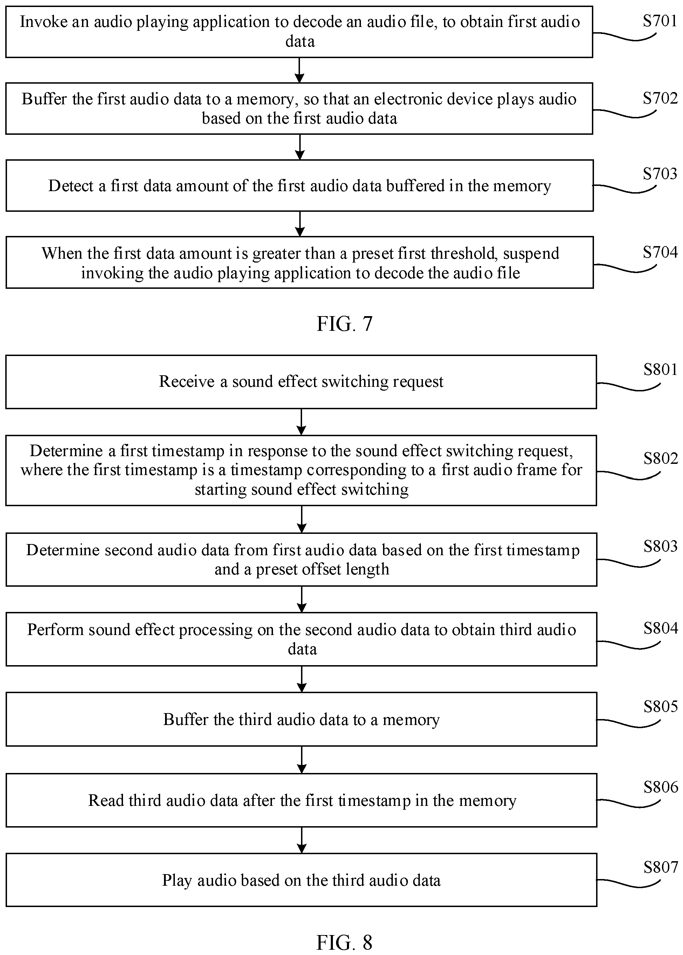

FIG. 7 is a schematic flowchart of a sound effect processing method according to an embodiment of this application. The method may be performed by using an electronic device. As shown in FIG. 7, the sound effect processing method provided in this embodiment of this application may include the following steps.

S701: Invoke an audio playing application to decode an audio stream, to obtain first audio data.

A plurality of audio playing applications are installed in the electronic device, for example, music software built in a system of the electronic device, third-party music software, and third-party book listening software. A processor (referring to the corresponding processing system in the embodiment in FIG. 2) in the electronic device may invoke the audio playing application. The processor is deployed with an audio processing algorithm, for example, an audio processing algorithm of an audio playing application provided by a system, or an audio processing algorithm of a third-party audio playing application. The processor may be an application processor, or may be another processor. This is not limited herein.

The electronic device invokes the audio playing application to decode an audio stream, to obtain first audio data. The audio processing algorithm deployed in the electronic device may support a plurality of audio formats, to ensure flexibility of audio data processing.

S702: Buffer the first audio data to the memory.

The first audio data is buffered in the memory, so that even if the electronic device suspends invoking the audio playing application to decode the audio stream (that is, suspends buffering the first audio data in the memory), the electronic device may further play audio based on the first audio data buffered in the memory, so that the electronic device can suspend invoking the audio playing application for more time, to reduce power consumption of the electronic device.

S703: Detect a first data amount of the first audio data buffered in the memory.

To ensure continuity of audio playing, the electronic device usually may continuously store audio data in the memory. To reduce the power consumption of the electronic device, the electronic device may detect the first data amount of the first audio data stored in the memory, to determine whether the first audio data stored in the memory can keep the electronic device playing audio for a period of time.

S704: When the first data amount is greater than a preset first threshold, suspend invoking the audio playing application to decode the audio stream.

When the first data amount of the first audio data buffered by the electronic device in the memory is greater than the preset first threshold, it indicates that even if the electronic device suspends buffering the first audio data in the memory, the electronic device may continue to play the audio for a period of time based on the first audio data stored in the memory. For example, a data amount of music data buffered by the electronic device in the memory is 100 M, that is, the memory buffers music data corresponding to about 10 songs. In this case, the electronic device may continuously play music for 30 minutes when the electronic device does not buffer the music data.

In some embodiments, when the electronic device is in a screen-off state, time for running the audio playing application by the electronic device may be reduced, thereby reducing the power consumption of the electronic device.

Because space of the audio data stored in the memory is limited, after the electronic device suspends buffering the first audio data in the memory (that is, suspends invoking the audio playing application to decode the audio stream) for a period of time, the electronic device further needs to resume invoking the audio playing application, to ensure continuity of audio playing. Specifically, when the electronic device suspends invoking the audio playing application to decode the audio stream, the electronic device may detect the second data amount of the first audio data read from the memory. In addition, when the second data amount is greater than a preset second threshold, the electronic device continues to invoke the audio playing application to decode the audio stream, to ensure continuity of audio playing.

In some embodiments, when buffering the first audio data in the memory, the electronic device further backs up the first audio data, to implement smoothness of sound effect switching.

As shown in FIG. 8, a sound effect switching method provided in this embodiment of this application may include S801 to S807.

S801: Receive a sound effect switching request.

A user may perform a sound effect switching operation by using a human-computer interaction interface of an audio playing application, so that an electronic device can receive the sound effect switching request. The request may be an instruction used to indicate to switch a sound effect.

S802: Determine a first timestamp in response to the sound effect switching request, where the first timestamp is a timestamp corresponding to a first audio frame for starting sound effect switching.

The electronic device backs up first audio data. The first audio data may include a plurality of frames of audio frames, and the first audio data may be time series data. Therefore, each audio frame corresponds to a timestamp, and the timestamp may indicate a sequence of each audio frame. After receiving the sound effect switching request, the electronic device may determine the first timestamp. The first audio frame corresponding to the first timestamp is an audio frame in which sound effect switching starts.

To ensure continuity of audio playing and accuracy of sound effect switching, and ensure user experience, the electronic device may determine the first timestamp based on a timestamp corresponding to a currently processed first audio frame. The first timestamp is greater than the timestamp corresponding to the currently processed first audio frame.

S803: Determine second audio data from the first audio data based on the first timestamp and a preset offset length.

In a sound effect switching process, the electronic device needs to continuously play audio. Therefore, the first timestamp is greater than the timestamp corresponding to the currently processed audio frame, that is, a playing time series of the audio frame for which sound effect switching starts is after the playing time series of the currently processed audio frame. To ensure accuracy of sound effect switching, the electronic device performs sound effect processing on an audio frame in a time series before the first timestamp, that is, subtract the offset length from the first timestamp to obtain a second timestamp. The electronic device performs sound effect switching processing on all audio frames after the second timestamp. It may be understood that the second timestamp is less than the first timestamp.

Herein, the second audio data includes an audio frame after the second timestamp in the first audio data. For example, if the first audio data backed up by the electronic device includes n audio frames, and a timestamp corresponding to the 20^{th} audio frame is the second timestamp, the second audio data includes the 21^{st} audio frame to the n^{th} audio frame. The first audio data backed up by the electronic device may be buffered in an application processor (as described in S605).

In some embodiments, to save storage space of the memory and avoid disorder of audio playing, the electronic device generates a data deletion instruction after obtaining the second timestamp through calculation. The data deletion instruction carries the second timestamp. After receiving the data deletion instruction, the memory deletes first audio data after the second timestamp in the memory, to avoid disorder of audio playing and implement smooth switching of a sound effect.

S804: Perform sound effect processing on the second audio data to obtain third audio data.

The electronic device invokes an algorithm corresponding to the audio playing application to perform sound effect processing on the second audio data, to obtain the third audio data.

S805: Buffer fourth audio data to the memory based on the offset length and the third audio data, where the third audio data includes the fourth audio data.

As described in S803, after obtaining the second timestamp through calculation, the electronic device deletes the first audio data after the second timestamp from the memory, to ensure smooth switching of a sound effect and avoid disorder of audio playing. Storage space obtained by deleting the first audio data after the second timestamp in the memory may be used to store the fourth audio data. A timestamp corresponding to a first audio frame of the fourth audio data is a next timestamp of the second timestamp.

Herein, the third audio data is audio data starting from the second timestamp, and an audio frame corresponding to the offset length may be deleted starting from the first audio frame of the third audio data. For example, if the third audio data includes the 21^{st} audio frame to the n^{th} audio frame, and the offset length is 30, the 21^{st} audio frame to the 51^{st} audio frame are all deleted.

S806: Read the fourth audio data from the memory.

The audio data read from the memory may be first audio data before sound effect switching, or may be fourth audio data after sound effect switching. When the fourth audio data of the first timestamp is read, a sound effect of audio played by the electronic device starts switching.

S807: Play audio based on the fourth audio data, to implement sound effect switching.

In this way, the memory buffers the audio data and then plays the audio, so that a sound effect can also be accurately switched, thereby ensuring continuity of audio playing and improving user experience.

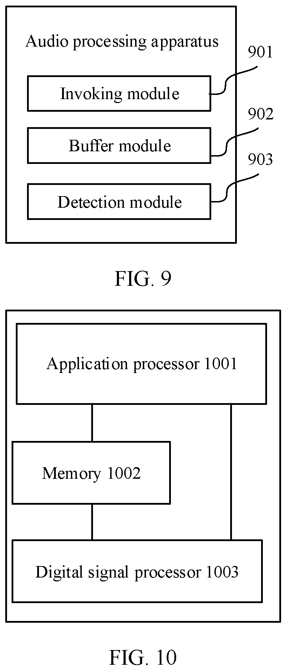

FIG. 9 shows an audio playing apparatus according to an embodiment of this application. The audio playing apparatus is applied to an electronic device, the electronic device includes a memory, and an audio playing application is installed in the electronic device.

As shown in FIG. 9, the audio playing apparatus provided in this embodiment of this application includes:
an invoking module 901, configured to invoke the audio playing application to decode an audio stream, to obtain first audio data;
a buffer module 902, configured to buffer the first audio data into the memory; and
a detection module 903, configured to detect a first data amount of the first audio data buffered in the memory.

The invoking module 901 is further configured to: when the first data amount is greater than a preset first threshold, suspend invoking the audio playing application.

When the electronic device is in a screen-off state and invoking of the audio playing application is suspended, the electronic device is configured to play audio based on the first audio data buffered in the memory.

In this embodiment of this application, the audio data is buffered in the memory. In this way, when the electronic device is in a screen-off state, and a data amount of the buffered audio data is greater than a preset first threshold, the electronic device may suspend invoking the audio playing application, and perform audio playing only by using the audio data buffered in the memory. This reduces power consumption of the electronic device.

In a possible implementation, the detection module 903 is further configured to: when suspending invoking the audio playing application, detect a second data amount of the first audio data read from the memory.

The invoking module 901 is further configured to: when the second data amount is greater than a preset second threshold, invoke the audio playing application to decode the audio stream.

In this way, when power consumption of the electronic device is reduced, continuity of audio playing can be further ensured, and user experience is improved.

In a possible implementation, the electronic device buffers the first audio data, the first audio data includes a plurality of audio frames and a timestamp corresponding to each of the plurality of audio frames, and the apparatus further includes:
a receiving module, configured to receive a sound effect switching request;
a determining module, configured to determine, in response to the sound effect switching request, a first timestamp corresponding to a first audio frame for starting sound effect switching;
the determining module is further configured to determine second audio data from the first audio data based on the first timestamp and a preset offset length;
a processing module, configured to perform sound effect processing on the second audio data to obtain third audio data;
the buffer module 902 is further configured to buffer fourth audio data to the memory based on the offset length and the third audio data, where the third audio data includes the fourth audio data;
a reading module, configured to read the fourth audio data from the memory; and
a play module, configured to play audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the determining module is configured to:
calculate a second timestamp based on the first timestamp and the preset offset length, where the second timestamp is less than the first timestamp; and
determine the second audio data from the first audio data based on the second timestamp.

In a possible implementation, the apparatus further includes:
a deletion module, configured to send a data deletion instruction to the memory, so that the memory deletes first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

In FIG. 10, an embodiment of this application provides an electronic device. As shown in FIG. 10, the electronic device provided in this embodiment of this application may include:
an application processor 1001, configured to invoke an audio playing application to decode an audio stream, to obtain first audio data;
a memory 1002, coupled to the application processor 1001, and configured to buffer the first audio data;
a digital signal processor 1003, separately coupled to the application processor 1001 and the memory 1002, and configured to read the first audio data from the memory, and perform audio mixing on the first audio data to obtain fifth audio data, so that the electronic device plays audio based on the fifth audio data; and
the application processor 1001 is further configured to detect a first data amount of the first audio data sent to the memory, and when the first data amount is greater than a preset first threshold, suspend invoking the audio playing application.

In this embodiment of this application, the audio data is buffered in the memory. In this way, when a data amount of the audio data buffered by the application processor into the memory is greater than the preset first threshold, the application processor may suspend invoking the audio playing application, so that the electronic device performs audio playing only by using the audio data buffered in the memory, to reduce power consumption of the electronic device.

In a possible implementation, the digital signal processor 1003 is further configured to: when the application processor suspends invoking the audio playing application, detect a second data amount of the first audio data read by the digital signal processor from the memory, and when the second data amount is greater than a preset second threshold, send a wake-up instruction to the application processor.

The application processor 1001 is configured to: in response to the wake-up instruction, continue to invoke the audio playing application to decode the audio stream, to obtain the first audio data.

In this way, when power consumption of the electronic device is reduced, continuity of audio playing can be further ensured, and user experience is improved.

In a possible implementation, that the application processor buffers the first audio data, the first audio data includes a plurality of audio frames and a timestamp corresponding to each of the plurality of audio frames includes:
the application processor 1001 is further configured to: receive a sound effect switching request, and send a sound effect switching instruction to the digital signal processor in response to the sound effect switching request;
the digital signal processor 1003 is further configured to: determine, based on the sound effect switching instruction, a first timestamp corresponding to a first audio frame for starting sound effect switching, and send the first timestamp to the application processor;
the application processor 1001 is further configured to: determine second audio data from the first audio data based on the first timestamp and a preset offset length, perform sound effect processing on the second audio data to obtain third audio data, and send fourth audio data to the memory based on the offset length and the third audio data, where the third audio data includes the fourth audio data; and
the digital signal processor 1003 is further configured to read the fourth audio data from the memory, so that the electronic device plays audio based on the fourth audio data, to implement sound effect switching.

In this way, the memory buffers the audio data and then plays the audio, so that a sound effect can also be accurately switched, thereby ensuring continuity of audio playing and improving user experience.

In a possible implementation, the application processor 1001 is specifically configured to:
calculate a second timestamp based on the first timestamp and the preset offset length, where the second timestamp is less than the first timestamp; and
determine the second audio data from the first audio data based on the second timestamp.

In a possible implementation, the application processor is further configured to send a data deletion instruction to the memory.

The memory is further configured to delete first audio data after the first timestamp in the memory in response to the data deletion instruction.

The data deletion instruction carries the first timestamp.

In this way, the user can be prevented from playing the audio before the sound effect switching after the sound effect switching, and this ensures accuracy of audio playing and improves user experience.

In a possible implementation, the application processor 1001 is further configured to receive an audio playing request, send the first audio data to the memory in response to the audio playing request, and send a data write instruction to the digital signal processor, where the data write instruction indicates that the application processor writes the first audio data to the memory.

The audio data signal processor 1003 is further configured to start reading the first audio data from the memory in response to the data write instruction.

With reference to the foregoing embodiments, an embodiment of this application further provides a computer program product. The computer program product is used to store a computer program. When the computer program is executed by a computer, the computer may implement the method provided in any one of the foregoing embodiments.

The method steps in embodiments of this application may be implemented in a hardware manner, or may be implemented in a manner of executing software instructions by the processor. The software instructions may include corresponding software modules. The software modules may be stored in a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or a storage medium in any other form well known in the art. For example, a storage medium is coupled to a processor, so that the processor can read information from the storage medium and write information into the storage medium. Certainly, the storage medium may be a component of the processor. The processor and the storage medium may be disposed in an ASIC.

All or some of the foregoing embodiments may be implemented by using software, hardware, firmware, or any combination thereof. When software is used to implement the embodiments, all or a part of the embodiments may be implemented in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instruction may be stored in a computer-readable storage medium, or may be transmitted by using the computer-readable storage medium. The computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

It may be understood that various numbers in embodiments of this application are merely used for differentiation for ease of description, and are not used to limit the scope of embodiments of this application.

## Claims

1. An audio playing method, applied to an electronic device, wherein the electronic device comprises a memory, and the method comprises:
invoking an audio playing application to decode an audio stream, to obtain first audio data;
buffering the first audio data to the memory, so that the electronic device plays audio based on the first audio data;
detecting a first data amount of the first audio data buffered in the memory; and
when the first data amount is greater than a preset first threshold, suspending invoking the audio playing application to decode the audio stream.

2. The method according to claim 1, wherein the method further comprises:
when suspending invoking the audio playing application to decode the audio stream, detecting a second data amount of the first audio data read from the memory; and
when the second data amount is greater than a preset second threshold, invoking the audio playing application to decode the audio stream.

3. The method according to claim 1, wherein the electronic device buffers the first audio data, the first audio data comprises a plurality of audio frames and a timestamp corresponding to each of the plurality of audio frames, and the method further comprises:
receiving a sound effect switching request;
determining a first timestamp in response to the sound effect switching request, wherein the first timestamp is a timestamp corresponding to a first audio frame for starting sound effect switching;
determining second audio data from the first audio data based on the first timestamp and a preset offset length;
performing sound effect processing on the second audio data to obtain third audio data;
buffering fourth audio data to the memory based on the offset length and the third audio data, wherein the third audio data comprises the fourth audio data;
reading the fourth audio data from the memory; and
playing audio based on the fourth audio data, to implement sound effect switching.

4. The method according to claim 3, wherein the determining second audio data from the first audio data based on the first timestamp and a preset offset length comprises:
calculating a second timestamp based on the first timestamp and the preset offset length, wherein the second timestamp is less than the first timestamp; and
determining the second audio data from the first audio data based on the second timestamp.

5. The method according to claim 3 or 4, wherein the method further comprises:
sending a data deletion instruction to the memory, so that the memory deletes first audio data after the first timestamp in the memory in response to the data deletion instruction, wherein
the data deletion instruction carries the first timestamp.

6. An audio playing method, applied to an electronic device, wherein the electronic device comprises an application processor, a memory, and a digital signal processor, wherein the memory is separately coupled to the application processor and the digital signal processor, the application processor is coupled to the digital signal processor, the application processor is configured to run an audio playing application, and the method comprises:
invoking, by the application processor, the audio playing application to decode an audio stream to obtain first audio data, and sending the first audio data to the memory, so that the memory buffers the first audio data;
reading, by the digital signal processor, the first audio data from the memory, and performing audio mixing on the first audio data, to obtain fifth audio data, so that the electronic device plays audio based on the fifth audio data; and
detecting, by the application processor, a first data amount of the first audio data sent to the memory, and when the first data amount is greater than a preset first threshold, suspending, by the application processor, invoking the audio playing application to decode the audio stream.

7. The method according to claim 6, wherein the method further comprises:
when the application processor suspends invoking the audio playing application to decode the audio stream, detecting, by the digital signal processor, a second data amount of the first audio data read by the digital signal processor from the memory, and when the second data amount is greater than a preset second threshold, sending a wake-up instruction to the application processor; and
in response to the wake-up instruction, invoking, by the application processor, the audio playing application to decode the audio stream, to obtain the first audio data, so as to send the first audio data to the memory.

8. The method according to claim 6, wherein the application processor buffers the first audio data, the first audio data comprises a plurality of audio frames and a timestamp corresponding to each of the plurality of audio frames, and the method further comprises:
receiving, by the application processor, a sound effect switching request, and sending a sound effect switching instruction to the digital signal processor in response to the sound effect switching request;
determining, by the digital signal processor based on the sound effect switching instruction, a first timestamp corresponding to a first audio frame for starting sound effect switching, and sending the first timestamp to the application processor;
determining, by the application processor, second audio data from the first audio data based on the first timestamp and a preset offset length, performing sound effect processing on the second audio data, to obtain third audio data, and sending fourth audio data to the memory based on the offset length and the third audio data, wherein the third audio data comprises the fourth audio data; and
reading, by the digital signal processor, the fourth audio data from the memory, so that the electronic device plays audio based on the fourth audio data, to implement sound effect switching.

9. The method according to claim 8, wherein the determining second audio data from the first audio data based on the first timestamp and a preset offset length comprises:
calculating a second timestamp based on the first timestamp and the preset offset length, wherein the second timestamp is less than the first timestamp; and
determining the second audio data from the first audio data based on the second timestamp.

10. The method according to claim 8 or 9, wherein the method further comprises:
sending, by the application processor, a data deletion instruction to the memory; and
deleting, by the memory, first audio data after the first timestamp in the memory in response to the data deletion instruction, wherein
the data deletion instruction carries the first timestamp.

11. The method according to any one of claims 6 to 9, wherein the method further comprises:
receiving, by the application processor, an audio playing request, sending the first audio data to the memory in response to the audio playing request, and sending a data write instruction to the digital signal processor, wherein the data write instruction indicates that the application processor writes the first audio data to the memory; and
reading, by the audio data signal processor, the first audio data from the memory in response to the data write instruction.

12. An audio playing apparatus, applied to an electronic device, wherein the electronic device comprises a memory, and the apparatus comprises:
an invoking module, configured to invoke an audio playing application to decode an audio stream, to obtain first audio data;
a buffer module, configured to buffer the first audio data to the memory, so that the electronic device plays audio based on the first audio data; and
a detection module, configured to detect a first data amount of the first audio data buffered in the memory, wherein
the invoking module is further configured to: when the first data amount is greater than a preset first threshold, suspend invoking the audio playing application to decode the audio stream.

13. The apparatus according to claim 12, wherein
the detection module is further configured to: when suspending invoking the audio playing application to decode the audio stream, detect a second data amount of the first audio data read from the memory; and
the invoking module is further configured to: when the second data amount is greater than a preset second threshold, invoke the audio playing application to decode the audio stream.

14. The apparatus according to claim 12, wherein the electronic device buffers the first audio data, the first audio data comprises a plurality of audio frames and a timestamp corresponding to each of the plurality of audio frames, and the apparatus further comprises:
a receiving module, configured to receive a sound effect switching request;
a determining module, configured to determine, in response to the sound effect switching request, a first timestamp corresponding to a first audio frame for starting sound effect switching, wherein
the determining module is further configured to determine second audio data from the first audio data based on the first timestamp and a preset offset length;
a processing module, configured to perform sound effect processing on the second audio data to obtain third audio data, wherein
the buffer module is further configured to buffer fourth audio data to the memory based on the offset length and the third audio data, wherein the third audio data comprises the fourth audio data;
a reading module, configured to read the fourth audio data from the memory; and
a play module, configured to play audio based on the fourth audio data, to implement sound effect switching.

15. The apparatus according to claim 14, wherein the determining module is configured to:
calculate a second timestamp based on the first timestamp and the preset offset length, wherein the second timestamp is less than the first timestamp; and
determine the second audio data from the first audio data based on the second timestamp.

16. The apparatus according to claim 14 or 15, wherein the apparatus further comprises:
a deletion module, configured to send a data deletion instruction to the memory, so that the memory deletes first audio data after the first timestamp in the memory in response to the data deletion instruction, wherein
the data deletion instruction carries the first timestamp.

17. An electronic device, comprising:
an application processor, configured to invoke an audio playing application to decode an audio stream, to obtain first audio data;
a memory, coupled to the application processor, and configured to buffer the first audio data; and
a digital signal processor, separately coupled to the application processor and the memory, configured to read the first audio data from the memory, and perform audio mixing on the first audio data, to obtain fifth audio data, so that the electronic device plays audio based on the fifth audio data, wherein
the application processor is further configured to detect a first data amount of the first audio data sent to the memory, and when the first data amount is greater than a preset first threshold, suspend invoking the audio playing application to decode the audio stream.

18. The electronic device according to claim 17, wherein
the digital signal processor is further configured to: when the application processor suspends invoking the audio playing application to decode the audio stream, detect a second data amount of the first audio data read by the digital signal processor from the memory, and when the second data amount is greater than a preset second threshold, send a wake-up instruction to the application processor; and
the application processor is configured to: in response to the wake-up instruction, continue to invoke the audio playing application to decode the audio stream, to obtain the first audio data.

19. The electronic device according to claim 17, wherein the application processor buffers the first audio data, and the first audio data comprises a plurality of audio frames and a timestamp corresponding to each of the plurality of audio frames, comprising:
the application processor is further configured to: receive a sound effect switching request, and send a sound effect switching instruction to the digital signal processor in response to the sound effect switching request;
the digital signal processor is further configured to: determine, based on the sound effect switching instruction, a first timestamp corresponding to a first audio frame for starting sound effect switching, and send the first timestamp to the application processor;
the application processor is further configured to: determine second audio data from the first audio data based on the first timestamp and a preset offset length, perform sound effect processing on the second audio data, to obtain third audio data, and send fourth audio data to the memory based on the offset length and the third audio data, wherein the third audio data comprises the fourth audio data; and
the digital signal processor is further configured to read the fourth audio data from the memory, so that the electronic device plays audio based on the fourth audio data, to implement sound effect switching.

20. The electronic device according to claim 19, wherein the application processor is specifically configured to:
calculate a second timestamp based on the first timestamp and the preset offset length, wherein the second timestamp is less than the first timestamp; and
determine the second audio data from the first audio data based on the second timestamp.

21. The electronic device according to claim 19 or 20, wherein
the application processor is further configured to send a data deletion instruction to the memory; and
the memory is further configured to delete first audio data after the first timestamp in the memory in response to the data deletion instruction, wherein
the data deletion instruction carries the first timestamp.

22. The electronic device according to any one of claims 17 to 20, wherein
the application processor is further configured to: receive an audio playing request, send the first audio data to the memory in response to the audio playing request, and send a data write instruction to the digital signal processor, wherein the data write instruction indicates that the application processor writes the first audio data to the memory; and
the audio data signal processor is further configured to start reading the first audio data from the memory in response to the data write instruction.

23. A computer storage medium, wherein the computer storage medium stores instructions, and when the instructions are run on an electronic device, the electronic device is enabled to perform the method according to any one of claims 1 to 5, or perform the method according to any one of claims 6 to 11.

24. A computer program product comprising instructions, wherein the computer program product is configured to store a computer program, and when the computer program is run on a computer, the computer is enabled to perform the method according to any one of claims 1 to 5, or perform the method according to any one of claims 6 to 11.
